# EUROPÄISCHE PATENTSCHRIFT

(11) **EP 1 129 245 B1**
(45) Veröffentlichungstag und Bekanntmachung des Hinweises auf die Patenterteilung: **23.01.2008**
(21) Anmeldenummer: 99972269.7
(22) Anmeldetag: 29.10.1999
(51) Int. Cl.: D04B 15/78

(54) **VERFAHREN UND VORRICHTUNG ZUR ANSTEUERUNG EINES PIEZOELEKTRISCHEN AKTORS**
METHOD AND DEVICE FOR CONTROLLING A PIEZOELECTRIC ACTUATOR
DISPOSITIF ET PROCEDE DE COMMANDE D'UN ACTIONNEUR PIEZO-ELECTRIQUE

(30) Priorität: 12.11.1998 DE 19852096
(43) Veröffentlichungstag der Anmeldung: 05.09.2001
(73) Patentinhaber: CATERPILLAR INC., Peoria, Illinois 61629-6490 (US)
(72) Erfinder: ITZHAKY, Itzhak, M., Plainview, NY 11803 (US)
(74) Vertreter: Wagner & Geyer
(86) Internationale Anmeldenummer: PCT/EP1999/008242
(87) Internationale Veröffentlichungsnummer: WO 2000/029652

(56) Entgegenhaltungen:
- EP-A- 0 796 939
- DE-A- 3 924 958
- DE-A- 3 933 149
- DE-C- 19 624 204
- PATENT ABSTRACTS OF JAPAN vol. 1997, no. 10, 31. Oktober 1997 (1997-10-31) & JP 09 141851 A (SEIKO EPSON CORP), 3. Juni 1997 (1997-06-03)
- PATENT ABSTRACTS OF JAPAN vol. 13, no. 564 (E-860), 14. Dezember 1989 (1989-12-14) & JP 01 235389 A (NEMOTO KAZUYUKI), 20. September 1989 (1989-09-20)

## Beschreibung

Die Erfindung bezieht sich auf ein Verfahren zur Ansteuerung eines piezoelektrischen Aktors als Nadelantrieb einer Textilmaschine, bei dem mittels eines Spannungsimpulses eine durch einen Anschlag begrenzte Bewegung des piezoelektrischen Aktors erzeugt wird. Sie bezieht sich weiter auf eine Vorrichtung zur Durchführung des Verfahrens.

Mittels eines derartigen piezoelektrischen Aktors wird eine elektrisch induzierte Formänderung eines piezoelektrischen Körpers für Antriebs- und Stellzwecke genutzt. Eine spezielle Form des Piezoaktors ist ein sogenannter piezoelektrischer Biegewandler, mit dem in einer einfachen Ausführung mit einem Laminat aus einer Piezokeramikschicht und einem inaktiven Substrat, z.B. einem metallischen Trägerblech, ein Biegeeffekt erreicht wird. Bei geeigneter elektrischer Ansteuerung zieht sich die Keramik geringfügig zusammen und ergibt durch die innere Verspannung des Laminats eine Durchbiegung. Die Auslenkung ist dabei wesentlich größer als die minimale Kontraktion der Piezoschicht, so dass ein derartiger Biegewandler mit einem inhärenten Übersetzungseffekt mit einer typischen Größenordnung von 10² arbeitet. Die Ansteuerung erfolgt dabei üblicherweise mittels eines rechteckförmigen Spannungsimpulses in Form einer an den Biegewandler angelegten positiven und/oder negativen Gleichspannung.

Derartige Biegewandler werden häufig in der Textilindustrie für Strick-, Wirk- und Webmaschinen als Nadelantriebsmechanismen eingesetzt. Ein derartiger Antriebsmechanismus für eine Strickmaschine ist beispielsweise aus der deutschen Patentschrift DE 39 33 149 C2 bekannt. Das als Biegewandler arbeitende Piezo-Element ist dabei an einem Ende direkt und am gegenüberliegenden Ende über einen mit diesem gekoppelten Antriebsfinger für die jeweilige Nadel drehbeweglich gehalten. Zwischen diesen beiden Lagepunkten ist eine ebenfalls drehbewegliche Stützfagerung vorgesehen, die durch deren wählbare Position zwischen dem Lager- und Koppelendpunkt eine Einstellung des Hubs des angekoppelten Antriebsfingers ermöglicht.

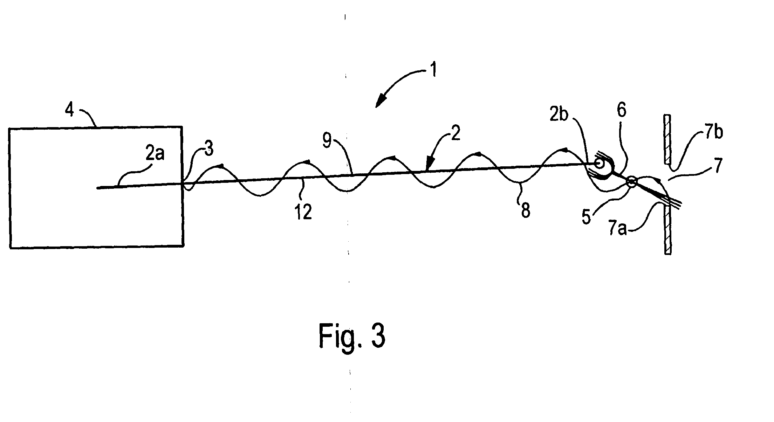

Eine schematische Darstellung üblicher Nadelantriebsmechanismen zeigt Fig. 3. Der Antriebsmechanismus umfasst einen piezoelektrischen Biegewandler 2, der mit seinem einen Ende 2a in eine Nut oder einen Schlitz 3 eines Basisblocks 4 eingesetzt und dort gehalten und fixiert ist. Der Biegewandler 2 ist an seinem gegenüberliegenden Ende 2b mit einem um eine Drehachse 5 schwenkbaren Antriebshebel oder Antriebsfinger 6 gekoppelt, dessen Freiende durch einen fensterartigen Ausschnitt 7 eines nicht näher dargestellten Gehäuses hindurch geführt ist. Der Antriebshebel 6 ist zwischen zwei durch den fensterartigen Ausschnitt 7 gebildeten, zueinander beabstandeten Anschlägen 7a und 7b verschwenkbar, durch die die Bewegung des Antriebshebels 6 und damit des Biegewandlers 2 begrenzt wird.

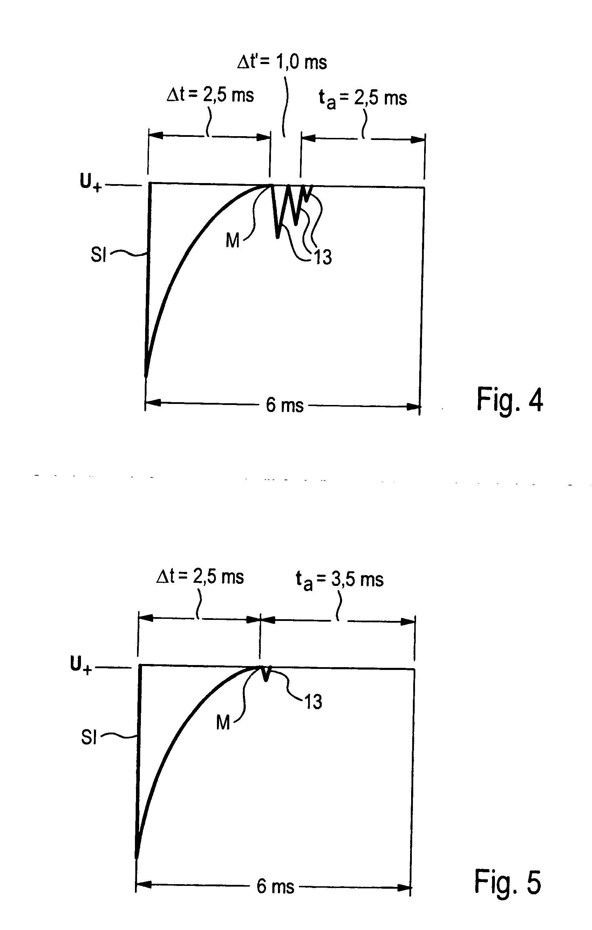

Problematisch bei diesem bekannten Antriebsmechanismus ist ein oszilloskopisch meßbarer Vibrationseffekt, der in Fig. 4 veranschaulicht ist. Dieser tritt bei jedem Steuerimpuls, d.h. bei Anlegen der Steuerspannung an den piezoelektrischen Biegewandler auf, wenn dessen Ausbiegungsverlauf mit im Vergleich zum steilflankigen Steuerimpuls flachem Flankenanstieg den Gleichgewichtszustand oder Soll-Ausschlag erreicht. Wie in Fig. 3 veranschaulicht, wird bei Erreichen des Soll-Ausschlags des Biegewandlers 2 der Antriebshebel 6 infolge des Aufpralls am Anschlag 7a in Vibration versetzt. Dabei treten bei Erreichen des dem Soll-Ausschlag entsprechenden konstanten Spannungspegels, der beispielsweise etwa 6ms andauert, nach etwa 2ms bis 3ms Überschwingungen um den Gleichgewichtszustand oder Soll-Ausschlag auf, die innerhalb etwa 1 ms bis 3ms langsam abklingen.

Diese Überschwingungen sind auf das Reaktionsverhalten des Piezo-Elements und auf das Aufprallen des Antriebsfingers zurückzuführen, der sich innerhalb eines Fensters aus seiner Ruhestellung zwischen den Anschlägen 7a,7b hin und her bewegt. Diese Überschwinger sind äußerst unerwünscht, da sie zu einer Verringerung der Lebensdauer des Piezo-Elements und damit des Antriebsmechanismus führen können. Außerdem ist durch die Überschwinger oder Vibrationen die Antriebsgeschwindigkeit der Nadeln um die Überschwingzeit von 1 ms bis 3ms verringert.

Ein mit diesem Effekt zusammenhängendes weiteres Problem tritt insbesondere bei Antriebsmechanismen auf, bei denen der Biegewandler an seinem ortsfesten Ende unbeweglich fixiert ist. Dabei breiten sich infolge des beim Anlegen des Spannungsimpulses erzeugten Aufprallimpulses des Antriebsfingers oder Koppelhebels 6 vom jeweiligen Anschlag 7a,7b ausgehende Stoßwellen 8 Ober den Antriebsfinger 6 und den mit diesem gekoppelten Biegewandler 2 bis zu dessen fixiertem Ende 2a aus. Durch die dadurch hervorgerufene mechanische Biegebelastung des Aktors tritt in der Praxis häufig nach bereits kurzer Betriebsdauer ein Anreißen oder Aufbrechen der piezokeramischen Schicht 9 am fixierten Ende 2a des Biegewandlers mit der Folge auf, dass der entsprechende Aktor ersetzt werden muß.

Ein anderes häufig auftretendes Problem ist der sogenannte Resonanzeffekt bei einem derartigen piezoelektrischen Aktor oder Biegewandler. Dieser Effekt der Resonanzfrequenz ist eine Erscheinung, die jedem piezoelektrischen Vorgang eigen ist. Wird an ein Piezoelement eine pulsierende Spannung angelegt, so wird dieses in Abhängigkeit vom Spannungspegel und/oder von der Impulsfrequenz in Schwingung versetzt. Durch schrittweise Erhöhung der Impulsspannung schneiden sich in einem bestimmten Punkt die Änderungen der mechanischen Bewegung des Piezoelements und der neu eintreffende Impuls mit der Folge, dass sich die Schwingung oder Vibrationen des Piezoelementes um ein Vielfaches erhöhen. Dies führt einerseits zu dem Problem, dass im Bereich der Resonanzfrequenz das Piezoelement praktisch völlig unkontrolliert arbeitet, was sich negativ auf die Leistung auswirkt. Andererseits schwingt das Piezoelement im Bereich der Resonanzfrequenz derart heftig, dass es beschädigt oder zerstört werden kann. Dabei ist der Bereich der Resonanzfrequenz von mehreren Faktoren abhängig, z. B. von der körperlichen Größe des Piezoelementes, von dessen Montageaufbau- oder methode, von der Impulsspannung und/oder von der Impulsfrequenz.

Der Erfindung liegt daher die Aufgabe zugrunde, ein Verfahren zur Ansteuerung eines piezolelektrischen Aktors als Nadelantrieb für eine Textilmaschine anzugeben, bei dem die geschilderten Nachteile zuverlässig vermieden sind. Darüber hinaus soll eine zur Durchführung des Verfahrens besonders geeignete Vorrichtung angegeben werden.

Bezüglich des Verfahrens wird die Aufgabe erfindungsgemäß gelöst durch die Merkmale des Anspruchs 1. Dazu ist vorgesehen, dem Spannungsimpuls einen diesem entgegengesetzt gerichteten Gegenimpuls mit vergleichsweise kurzer lmpulsdauer vor Erreichen einer Endposition der dem Spannungsimpuls nacheilenden Bewegung des Aktors zu überlagern. Dabei wird nach Erreichen des Soll-Spannungspegels die Steuerspannung auf Null gesetzt oder vorzugsweise umgepolt und ein entsprechend steilflankiger und vergleichsweise kurzzeitiger Gegenimpuls erzeugt.

Zwar ist aus der DE 39 24 958 A1 eine Schaltungsanordnung zum Ansteuern von Schreibdüsen einer Tintenmosaikschreibeinrichtung bekannt, bei der zur Erzeugung eines gezielten Flüssigkeitsausstoßes ein Piezoelement mittels einer Gleichspannung derart angesteuert wird, dass ausgehend von einem oberhalb eines Mittelwertes liegenden Spannungswert, bei dem infolge eines durch das Piezoelement erzeugten Druckvorgangs eine Verengung eines Schreibflüssigkeit führenden Kanals bewirkt wird, durch anschließendes Abschalten der Gleichspannung das Piezoelement auf Null Volt (0V) entladen wird mit der Folge, dass sich der Kanal erneut aufweitet. Diese bekannte Schaltungsanordnung ist jedoch weder geeignet noch dazu vorgesehen, die genannten Vibrations- oder Überschwingeffekte zuverlässig zu vermeiden. Eine kurzzeitige Abschaltung der Steuerspannung eines piezoelektrischen Aktors auf Null Volt ist auch aus der JP-A-09-141851 bekannt.

Auch kann zwar durch einen geeigneten Schichtaufbau eines piezoelektrischen Biegewandlers dessen Eigenschwingungsverhalten sowie die Dämpfung beeinflußt werden, wie dies in der DE 196 24 204 C1 bei der Darlegung des Standes der Technik ausgeführt ist. Allerdings sind auch derartige Maßnahmen weder geeignet noch dazu vorgesehen, die genannten Vibrations- oder Überschwingeffekte zuverlässig zu vermeiden.

Der Zeitpunkt der Generierung des Gegenimpulses wird dabei zweckmäßigerweise bestimmt durch den dem Spannungsimpuls nacheilenden Ausbiegungsverfauf oder der Biegebewegung des Aktors. Dazu wird dieser Gegenimpuls zu dem Zeitpunkt gesetzt, bei dem die Bewegung des Aktors gerade nicht durch einen Anschlag abrupt gestoppt wird. Dieser Zeitpunkt kann im Bereich von 0,5ms bis 5ms, vorzugsweise 2ms bis 3ms, nach Erreichen des Soll-Spannungspegels liegen. Als besonders vorteilhafter Zeitpunkt hat sich die Erzeugung des Gegenimpulses etwa 2,5ms nach Erreichen des Soll-Spannungspegels herausgestellt. Danach ist nachweislich bei den üblicherweise verwendeten Geometrien von Nadelantriebsmechanismen und daraus resultierenden Fensterbreiten der Soll-Ausschlag oder Gleichgewichtszustand des dem Spannungsimpuls zeitverzögert folgenden Ausbiegungsverlaufs des Biegewandlers erreicht. Der Gegenimpuls, d.h. der dem zur Ansteuerung dienenden Steuerimpuls entgegengesetzt gerichtete Spannungsimpuls weist zweckmäßigerweise eine im Vergleich zum Spannungsimpuls große Amplitude auf. Diese Amplitude kann sich bei einem sowohl im positiven als auch im negativen liegenden Spannungsimpuls über die Nulllinie hinaus bis in den negativen bzw. positiven Spannungsbereich erstrecken.

Der Gegenimpuls ist dabei zeitlich derart bemessen, dass dadurch die Ausbiegungsbewegung des Aktors gestoppt oder zumindest gedämpft wird. Die Ausbiegung des Biegewandlers soll sich dabei gerade noch nicht umkehren, so dass sich anschaulich die Ausbiegungskurve oder der Ausbiegungsverlauf im Bereich des Soll-Ausschlags sanft an den steilflankigen Spannungsverlauf anschmiegen kann. Die Zeitdauer des Gegenimpulses liegt zweckmäßigerweise im µs-Bereich, wobei sich eine Impulsdauer von 25µs als besonders vorteilhaft herausgestellt hat. Die Zeitdauer des Gegenimpulses kann jedoch auch im Bereich von 3µs bis 3ms, vorzugsweise 5µs bis 50µs, liegen.

Der Spannungsimpuls zur Ansteuerung des Biegewandlers oder Aktors wird nach Ablauf der Impulsdauer des Gegenimpulses durch Umpolung wieder eingeschaltet, bevor der Biegewandler den Ausbiegungswendepunkt erreicht hat. Anstelle eines einzelnen Gegenimpulses bestimmter Amplitude und bestimmter Zeitdauer kann auch die Überschwingung durch eine Anzahl von Gegenimpulsen unterschiedlicher Amplitude ausgeregelt werden. Dazu kann beispielsweise der Ausbiegungsverlauf des Biegewandlers sensorisch erfasst werden, wozu zweckmäßigerweise der Steuerstrom herangezogen wird.

Durch die kurzzeitige Anwendung des Gegen- oder Umkehrimpulses werden der Ausschlag oder die Auslenkung und die Biege- oder Dehnungskraft des Biegewandlers oder Piezoelements nicht beeinträchtigt, während der zusätzliche Gegen-Impuls den Effekt der Resonanzfrequenz beseitigt oder kompensiert.

Bezüglich der Vorrichtung wird die genannte Aufgabe erfindungsgemäß gelöst durch die Merkmale des Anspruchs 5. Vorteilhafte Ausgestaltungen sind Gegenstand der auf diesen rückbezogenen Unteransprüche.

Die mit der Erfindung erzielten Vorteile bestehen insbesondere darin, dass durch gezielte Überlagerung eines Steuer- oder Spannungsimpulses zur Ansteuerung eines piezoelektrischen Aktors, insbesondere eines Biegewandlers, mit einem dem Steuerimpuls entgegengesetzt gerichteten Gegenimpuls eine Beschädigung oder Zerstörung des piezoelektrischen Aktors infolge einer bei der Ansteuerung erzeugten mechanischen Belastung vermieden sind. Dabei werden bei einer derartigen Ansteuerung eines solchen Piezoelementes auch Resonanzeffekte mittels des zusätzlichen Gegenimpulses unterdrückt bzw. durch dessen Entgegenwirken kompensiert. Die Lebensdauer des piezoelektrischen Aktors ist somit erheblich erhöht. Dies ist bei einem piezoelektrischen Biegewandler als Antriebsmechanismus für eine Textilmaschine von erheblicher wirtschaftlicher Bedeutung, da dadurch unerwünschte Stillstandszeiten entsprechender Strick-, Wlrk- oder Webmaschinen erheblich reduziert werden können.

Ein weiterer Vorteil dieses Ansteuerverfahrens und dieser Ansteuervorrichtung besteht darin, dass bei einem derart angesteuerten Biegewandler dessen Arbeitsgeschwindigkeit und damit die Ansprechgeschwindigkeit eines Antriebsmechanismus einer Textilmaschine im Vergleich zu einem konventionellen Antriebsmechanismus erheblich erhöht ist. Grund hierfür ist, dass durch Vermeidung der Vibrationen oder Überschwingungen infolge des Anschlagens des mit dem Biegewandler gekoppelten Antriebsfingers praktisch kein instabiler Zustand mehr vorhanden ist.

Bei konventionellen Antriebsmechanismen beträgt die Zeitdauer, während infolge der Vibrationen ein instabiler und für den Antrieb nicht nutzbarer Zustand besteht, etwa 1 ms. Demzufolge ist der Arbeitsbereich eines entsprechenden Antriebsmechanismus während einer Impulsdauer des Spannungsimpulses von beispielsweise 6ms und einer üblichen Verzögerungsdauer des dem steilflankigen Spannungsimpulses nacheilenden Soll-Ausschlages des Biegewandlers von etwa 2,5ms auf eine Zeitdauer von 2,5ms begrenzt. Demgegenüber ist der Arbeitsbereich bei der erfindungsgemäßen Ansteuerung auf 3,5ms erhöht. Dies bedeutet, dass eine entsprechend angesteuerte Textilmaschine um ca. 1 ms schneller arbeiten kann. Dies wiederum bedeutet, dass die Taktzeit um ca. 1 ms verringert werden kann.

Nachfolgend wird ein Ausführungsbeispiel der Erfindung anhand einer Zeichnung näher erläutert. Darin zeigen:
- Fig. 1: schematisch einen Antriebsmechanismus mit einem piezoelektrischen Biegewandler und einem diesen ansteuernden Impulsgenerator,
- Fig. 2: den Verlauf eines Spannungsimpulses zur Ansteuerung des Biegewandlers,
- Fig. 3: eine Veranschaulichung eines Vibrations- und Stoßwelleneffektes bei einem bekannten Antriebsmechanismus,
- Fig. 4: einen Ausbiegungsverlauf eines in bekannter Weise angesteuerten Biegewandlers mit Vibrations- und Schockwelleneffekt, und
- Fig. 5: einen Ausbiegungsverlauf eines erfindungsgemäß angesteuerten Biegewandlers.

Einander entsprechende Teile sind in allen Figuren mit den gleichen Bezugszeichen versehen.

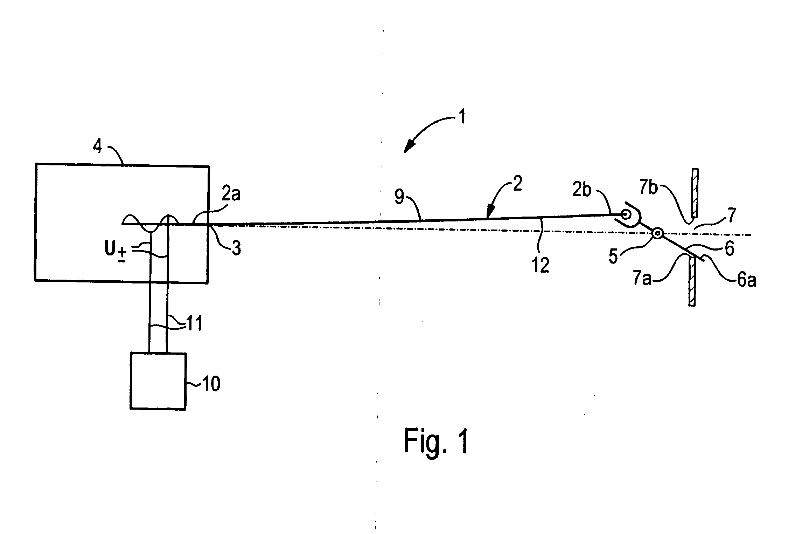

Fig. 1 zeigt schematisch einen Antriebsmechanismus 1 mit einem Biegewandler 2, dessen Fixierende 2a in einem nichtgleitenden festen Basisblock 4 ortsfest gehalten ist. Das Fixierende 2a kann jedoch auch längs- und/oder drehbeweglich im Basisblock 4 gehalten sein. Das gegenüberliegende Koppelende 2b des piezoelektrischen Biegewandlers 2 wirkt mit einem um einen Drehpunkt oder eine Drehachse 5 schwenkbar gelagerten Antriebsfinger oder Antriebshebel 6 zusammen. Das antriebsfreie Ende 6a des Antriebshebels 6 ist durch einen in einem nicht näher dargestellten Gehäuse vorgesehenen fensterartigen Ausschnitt 7 geführt, der einen unteren Anschlag 7a und einen zu diesem beabstandeten oberen Anschlag 7b bildet. Ein derartiger Antriebsmechanismus 1 wird üblicherweise als Nadelantrieb für eine Strick-, Web- oder Wirkmaschine in der Textilindustrie zum Stricken oder Weben von Textilien eingesetzt.

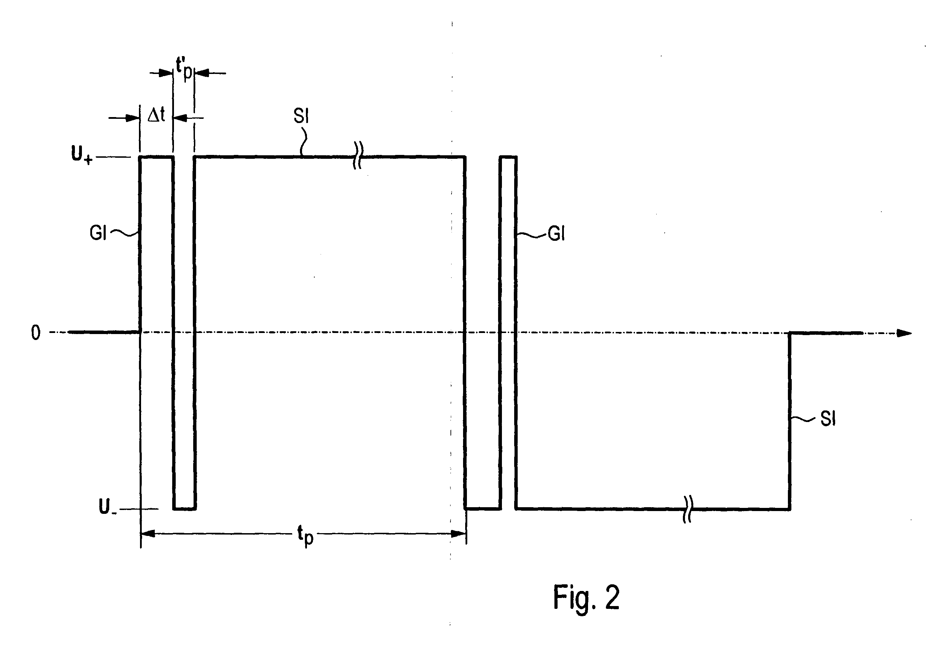

Der piezoelektrische Biegewandler 2 wird mittels eines von einem Impulsgenerator 10 erzeugten Spannungsimpuls SI angesteuert, der in Figur 2 dargestellt ist. Dazu wird an den Biegewandler 2, der über Anschlußleitungen 11 mit dem Impulsgenerator 10 elektrisch verbunden ist, eine Gleichspannung U_{±} angelegt, deren Impulsdauer oder Pulszeit tₚ z. B. zwischen 5ms und 200ms betragen kann. Der Spannungsimpuls SI wird durch Einschalten der Gleichspannung U_{±} als Rechteckimpuls generiert, der je nach Ausbiegungsrichtung des Biegewandlers 2 bezogen auf die Nulllinie im Positiven oder Negativen verläuft. Bei positiver Amplitude des Spannungsimpulses SI erfolgt eine Ausbiegung des Biegewandlers 2 in eine Richtung, während der an diesen angekoppelte Antriebshebel 6 in die entgegengesetzte Richtung ausgelenkt wird.

Zur Vermeidung des einleitend anhand der Figuren 3 und 4 beschriebenen Vibrations- und/oder Stoßwelleneffektes wird dem Spannungsimpuls SI ein Gegenimpuls GI überlagert. Dies wird durch Abschalten der Steuerspannung U_{±} oder durch Umpolen der Steuerspannung U_{±} erreicht. Der Einschaltzeitpunkt des Gegenimpulses GI ist dabei derart bemessen, dass der Soll-Pegel U₊ bzw. U₋ des Spannungsimpulses SI erreicht und die zeitverzögert nachfolgende Ausbiegung des Biegewandlers 2 sich dem Maximum M nähert. Dies ist in Fig. 4 und 5 veranschaulicht.

Kurz vor Erreichen des Soll- oder Maximalausschlages M des Biegewandlers 2 erfolgt die Einschaltung des Gegenimpulses GI mit einer im Vergleich zur Impulsdauer tₚ kurzen Impulsdauer t'ₚ. Der Einschaltzeitpunkt Δt des Gegenimpulses Gl hängt unter anderem von der Materialzusammensetzung der auf einen z. B. metallischen oder aus Kunststoff bestehenden Träger 12 aufgebrachten Piezokeramik 9 des Biegewandlers 2 und von der Geometrie des Antriebsmechanismus 1 ab und beträgt typisch Δt = 2,5ms. Die Impulsdauer t'ₚ des Gegenimpulses Gl liegt vorzugsweise im µs-Bereich, wobei sich eine Impulsdauer t'p von 25µs als besonders vorteilhaft herausgestellt hat.

Der dem Spannungsimpuls SI überlagerte Gegenimpuls Gl bewirkt ein Abbremsen der Ausbiegungsbewegung des Biegewandlers 2 bis zu einem Wendepunkt, an dem die Ausbiegungsbewegung des Biegewandlers 2 in die entgegengesetzte Richtung übergeht. Die Impulsdauer t'ₚ des Gegenimpulses GI ist daher derart bemessen, dass sich die Richtung der Ausbiegungsbewegung des Biegewandlers 2 gerade nicht umkehrt. Zu diesem Zeitpunkt wird der piezoelektrische Biegewandler 2 wieder vom Spannungsimpuls SI angesteuert. Dazu wird die Steuerspannung U_{±} wieder eingeschaltet oder umgepolt. Infolge des dem Spannungs- oder Steuerimpulses SI überlagerten Gegenimpuls Gl wird der Ausbiegungsverlauf oder die Ausbiegungsbewegung des Biegewandlers 2 vor Erreichen des jeweiligen Anschlags 7a,7b abgebremst oder gedämpft, so dass sich der Antriebshebel 6 praktisch stoßfrei an den entsprechenden Anschlag 7a bzw. 7b anlegt.

Der entsprechende mechanische Ausbiegungsverlauf des Biegewandlers 2 bis zur Anlage am jeweiligen Anschlag 7a,7b ist in Fig. 5 veranschaulicht. Aus dieser oszilloskopischen Darstellung ist ersichtlich, dass nur noch vernachlässigbare Überschwinger 13 auftreten. Im Vergleich dazu zeigt Fig. 4 mehrere Überschwinger 13 vergleichsweise großer Amplitude, die während einer Impulsdauer tₚ von ca. 1 ms auftreten. Daraus ergibt sich bei den im Ausführungsbeispiel gewählten Werten, d. h. bei einer Impulsdauer tₚ von im Ausführungsbeispiel 6ms ein Arbeitsbereich oder eine effektiv nutzbare Antriebszeit von tₐ = 2,5ms. Bei der erfindungsgemäßen Ansteuerung ergibt sich innerhalb derselben Impulsdauer tₚ von 6ms des piezoelektrischen Biegewandlers 2 ein verlängerter Arbeitsbereich von tₐ = 3,5ms. Demzufolge kann die mit einem derart angesteuerten Antriebsmechanismus 1 arbeitende Textilmaschine mit einer entsprechend höheren Antriebsgeschwindigkeit betrieben werden.

### Bezugszeichenliste

- 1: Antriebsmechanismus
- 2: Aktor/Biegewandler
- 2a: Fixierende
- 2b: Koppelende
- 3: Schlitz
- 4: Basisblock
- 5: Drehachse
- 6: Antriebshebel
- 7: Ausschnitt
- 7a,b: Anschlag
- 8: Stoßwelle
- 9: Piezokeramik
- 10: Impulsgenerator
- 11: Anschlussleitung
- 12: Trägerplatte
- 13: Überschwinger

- EI: Gegenimpuls
- SI: Spannungs-/Steuerimpuls
- M: Endposition/Sollausschlag
- U₊,U₋: Soll-Pegel
- tₐ: Antriebszeit
- tₚ: Impulsdauer
- Δt: Einschaltzeitpunkt

## Patentansprüche

1. Verfahren zur Ansteuerung eines piezoelektrischen Aktors (2) als Nadelantriebsmechanismus (1) für eine Textilmaschine, insbesondere für eine Strick-, Web- oder Wirkmaschine, bei dem mittels eines Spannungsimpulses (SI) eine durch einen Anschlag (7a,7b) begrenzte Bewegung des piezoelektrischen Aktors (2) erzeugt wird, wobei nach Erreichen eines Soll-Pegels (U₊,U₋) des Spannungsimpulses (SI) diesem ein entgegengesetzt gerichteter Spannungsimpuls (GI) vergleichsweise kurzer impulsdauer (t'ₚ) überlagert wird, und zwar vor Erreichen einen Endposition (M) der dem Spannungsimpuls (SI) nacheilenden Bewegung des Aktors (2)

2. Verfahren nach Anspruch 1,
**dadurch gekennzeichnet,**
**dass** die Amplitude des entgegengesetzt gerichteten Spannungsimpulses (G1) größer ist als die Amplitude des überlagerten Spannungsimpulses (SI).

3. Verfahren nach Anspruch 1 oder 2,
**dadurch gekennzeichnet,**
**dass** der entgegengesetzt gerichtete Spannungsimpuls (GI) nach einer Impulsdauer (Δt) von 0,5ms bls 5ms, vorzugsweise 2ms bis 3ms, des überlagerten Spannungsimpulses (SI) erzeugt wird.

4. Verfahren nach einem der Ansprüche 1 bis 3,
**dadurch gekennzeichnet,**
**dass** der entgegengesetzt gerichtete Spannungsimpuls (Gl) mit einer Impulsdauer (t'ₚ) von 3µs bis 3ms, vorzugsweise 5µs bis 50µs, erzeugt wird.

5. Vorrichtung zur Ansteuerung eines piezoelektrischen Aktors (2) als Nadelantriebsmechanismus (1) für eine Textilmaschine, insbesondere für eine Strick-. Web- oder Wirkmaschine, mit einem Impulsgenerator (10), der einen Spannungsimpuls (SI) mit einstellbarer Impulsdauer (tₚ) und vorgebbarem Soll-Pegel (U₊, U₋) erzeugt,
- wobei der Aktor (2) an einem Fixierende (2a) gehalten ist und am diesem abgewandten Koppelende (2b) mit einem Antriebshebel (6) gekoppelt ist, der in einem Drehpunkt (5) gelagert und freiendseitig zwischen zwei Anschlägen (7a,7b) verschwenkbar ist, und
- wobei der Impulsgenerator (10) nach Erreichen des Soll-Pegels (U₊, U₋) und vor Erreichen einer Endposition (M) der dem Spannungsimpuls (S1) nacheilenden Bewegung des Aktors (2) einen Gegenimpuls (GI) erzeugt.

6. Vorrichtung nach Anspruch 5,
**dadurch gekennzeichnet,**
**dass** der Aktor ein aus einer Piezökeramikschicht (9) und einer Trägerplatte (12) aufgebauter und über eine Ansteuerleitung (11) mit dem Impulsgenerator (10) verbundener Biegewandler (2) ist.

## Claims

1. A method for controlling a piezoelectric actuator (2) as a needle drive for a textile machine, in particular for a warp or weft knitting or a weaving machine, in which by means of a voltage pulse (SI) a motion of the piezoelectric actuator (2) is generated, which motion is limited by a stopper (7a, 7b), wherein after reaching a target level (U₊, U₋) of the voltage pulse (SI), an opposed voltage pulse (Gl) having a comparatively brief pulse duration (t'ₚ) is superimposed thereon, before the actuator (2) reaches its end position (M) of the movement following the voltage pulse (SI).

2. The method according to claim 1, **characterised in that** the amplitude of the opposed voltage pulse (GI), is higher than the amplitude of the voltage pulse (SI), which is being superimposed.

3. The method according to claim 1 or 2, **characterised in that** the opposed voltage pulse (Gl) is preferably generated after a pulse duration (Δt) of 0,5ms to 5ms, preferably 2ms to 3ms, of the voltage pulse (SI), which is being superimposed.

4. The method according to any one of claims 1 to 3, **characterised in that** the opposed voltage pulse (Gl) is generated to have a pulse duration (t'ₚ) in the range of 3µs to 3ms, preferably in the range of 5µs to 50µs.

5. An apparatus for controlling a piezoelectric actuator (2) as a needle drive for a textile machine, in particular for a warp or weft knitting or a weaving machine, said apparatus having a pulse generator (10), which generates a voltage pulse (Sl) having an adjustable pulse duration (tₚ) and a predetermined target level (U₊, U₋),
wherein said actuator (2) is fixed at a fixing end (2a) and is coupled at an opposite coupling end (2b) to a drive arm (6), which is journaled at a pivot point (5), the free end of the drive arm being pivotable between two stoppers (7a, 7b), and
wherein the pulse generator (10) before reaching the target level (U₊, U₋) and before the actuator (2) reaches its end position (M) of the movement following the voltage pulse (SI) generates an opposed impulse (GI).

6. The apparatus according to claim 5, **characterised in that** the actuator is a bending transducer (2) formed of a piezo-ceramic layer (9) and a carrier plate (12), said bending transducer (2) being connected to the pulse generator (10) via a control line (11).

## Revendications

1. Procédé de commande d'un actionneur piézoélectrique (2) sous la forme d'un mécanisme d'entraînement d'aiguilles (1) pour une machine textile, en particulier pour une machine à tricoter, à tisser ou à mailler, dans lequel on génère un mouvement de l'actionneur piézoélectrique (2) limité par une butée (7a,7b) au moyen d'une impulsion de tension (SI), en faisant en sorte, après avoir atteint un niveau théorique (U₊, U₋) de l'impulsion de tension (SI), de superposer à celle-ci une impulsion de tension dirigée en sens inverse (GI) d'une durée d'impulsion relativement courte (t'ₚ) et ce, avant d'atteindre une position terminale (M) du mouvement de l'actionneur (2) postérieur à l'impulsion de tension (SI).

2. Procédé selon la revendication 1, **caractérisé en ce que** l'amplitude de l'impulsion de tension dirigée en sens inverse (GI) est supérieure à celle de l'impulsion de tension superposée (SI).

3. Procédé selon la revendication 1 ou 2, **caractérisé en ce que** l'impulsion de tension dirigée en sens inverse (GI) est générée après une durée d'impulsion (Δt) de 0,5 ms à 5 ms, de préférence de 2 ms à 3 ms, de l'impulsion de tension superposée (SI).

4. Procédé selon l'une quelconque des revendications 1 à 3, **caractérisé en ce que** l'impulsion de tension dirigée en sens opposé (GI) est générée avec une durée d'impulsion (t'p) de 3 µs à 3 ms, de préférence de 5 µs à 50 µs.

5. Dispositif pour commander un actionneur piézoélectrique (2) sous la forme d'un mécanisme d'entraînement d'aiguilles (1) pour une machine textile, en particulier pour une machine à tricoter, à tisser ou à mailler, comprenant un générateur d'impulsions (10) qui génère une impulsion de tension (SI) d'une durée d'impulsion réglable (tₚ) et un niveau théorique prédéterminable (U₊, U₋),
- dans lequel l'actionneur (2) est maintenu à une extrémité de fixation (2a) et couplé, à l'extrémité de couplage opposée (2b), à un levier d'entraînement (6), qui est monté sur un pivot (5) et peut pivoter du côté de l'extrémité libre entre deux butées (7a, 7b), et
- dans lequel le générateur d'impulsions (10) génère une contre-impulsion (GI) après avoir atteint le niveau théorique (U₊, U₋) et avant d'atteindre une position terminale (M) du mouvement de l'actionneur (2) postérieur à l'impulsion de tension (SI).

6. Dispositif selon la revendication 5, **caractérisé en ce que** l'actionneur est un transducteur de flexion (2) qui est formé d'une couche de céramique piézoélectrique (9) et d'une plaque de support (12) et connecté au générateur d'impulsions (10) via une ligne de commande (11).
